# EUROPEAN PATENT APPLICATION

(11) **EP 4 465 057 A1**
(43) Date of publication of application: **20.11.2024**
(21) Application number: 22931449.7
(22) Date of filing: 18.03.2022
(51) Int. Cl.: G01R 31/28

(54) **CHIP SYSTEM AND ELECTRONIC DEVICE**

(71) Applicant: Huawei Technologies Co., Ltd., Shenzhen, Guangdong 518129 (CN)
(72) Inventor: LIU, Yilu, Shenzhen, Guangdong 518129 (CN); WANG, Xiaojun, Shenzhen, Guangdong 518129 (CN); WANG, Guangwei, Shenzhen, Guangdong 518129 (CN); CONG, Xiaodong, Shenzhen, Guangdong 518129 (CN); ZHANG, Taotao, Shenzhen, Guangdong 518129 (CN)
(74) Representative: Körber, Martin Hans
(86) International application number: PCT/CN2022/081764
(87) International publication number: WO 2023/173418

(57) **Abstract**

This disclosure provides a chip system and an electronic device, and belongs to the field of electronic technologies. The chip system includes a BGA chip (1), a PCB (2), a signal source module (3), and a detection module (4). A function pin (111) of the BGA chip (1) is soldered to a function solder pad (21) of the PCB (2) by using a first solder ball (6), and a detection pin (112) of the BGA chip (1) is soldered to a detection solder pad (22) of the PCB (2) by using a second solder ball (7). A designed life of the second solder ball (7) is shorter than a designed life of the first solder ball (6). A detection path (10) is formed between the BGA chip (1) and the PCB (2), and the detection path (10) includes the second solder ball (7). The signal source module (3) is configured to send a detection signal to the detection module (4) through the detection path (10), and the detection module (4) is configured to determine a status of the detection path (10) based on the received detection signal.

## Description

### TECHNICAL FIELD

This disclosure relates to the field of electronic technologies, and in particular, to a chip system and an electronic device.

### BACKGROUND

A ball grid array (ball grid array, BGA) chip is soldered to a printed circuit board (printed circuit board, PCB) by using a solder ball, and a signal can be transmitted between the BGA chip and the PCB by using the solder ball.

However, in a process of using the BGA chip, the solder ball may crack due to various types of stress, and this may affect quality of the transmitted signal and even causes a signal disconnection.

### SUMMARY

This disclosure provides a chip system and an electronic device. The chip system provided in this disclosure can predict a status of a first solder ball between a function pin of a BGA chip and a function solder pad of a PCB by monitoring a status of a second solder ball between a detection pin of the BGA chip and a detection solder pad of the PCB, so that measures can be taken in a timely manner to delay or even avoid cracking of the first solder ball, to improve reliability of the chip system. Technical solutions of the chip system and the electronic device are described as follows.

According to a first aspect, this disclosure provides a chip system. The chip system includes a ball grid array (ball grid array, BGA) chip, a printed circuit board (printed circuit board, PCB), a signal source module, and a detection module. The BGA chip has a plurality of function pins and at least one detection pin, and the PCB has a plurality of function solder pads and at least one detection solder pad. The function pin is soldered to the function solder pad by using a first solder ball, and the detection pin is soldered to the detection solder pad by using a second solder ball. At least one detection path is formed between the BGA chip and the PCB, the detection path includes one or more unit circuits connected in series, and the unit circuit includes the detection pin, the second solder ball, and the detection solder pad that are connected in sequence. The signal source module is configured to send a detection signal to the detection module through the at least one detection path, and the detection module is configured to determine a status of the at least one detection path based on the received detection signal.

The function pin of the BGA chip may be a pin used to implement a basic function of the BGA chip, for example, a power pin, a ground pin, and a function pin. The power pin is a pin that provides a connection for a power supply of the BGA chip, the ground pin is a pin that provides a connection for grounding the BGA chip, and the function pin is a pin that provides a connection for a signal needed by the BGA chip. When the first solder ball between the function pin and the function solder pad cracks, a function or performance of the BGA chip may be affected.

The detection pin of the BGA chip may be a pin specially used to monitor a status of the second solder ball. The detection pin 112 may not have other functions except status monitoring. When the second solder ball between the detection pin and the detection solder pad cracks, the BGA chip can still work normally.

The function solder pad of the PCB refers to a solder pad soldered to the function pin, and the detection solder pad of the PCB refers to a solder pad soldered to the detection pin.

The first solder ball is located between the function pin and the function solder pad, and the second solder ball is located between the detection pin and the detection solder pad. A designed life of the second solder ball is shorter than a designed life of the first solder ball. Therefore, in a normal case, the second solder ball may crack before the first solder ball. Therefore, a status of the first solder ball may be predicted by monitoring the status of the second solder ball.

The signal source module is configured to generate the detection signal, and send the detection signal to the detection module through the detection path. The detection module is configured to receive the detection signal through the detection path, and determine the status of the detection path based on the received detection signal, in other words, determine the status of the second solder ball included in the detection path.

According to the technical solution provided in this disclosure, the detection path is formed between the BGA chip and the PCB of the chip system, and the detection path includes the second solder ball. The signal source module can send the detection signal to the detection module through the detection path, and the detection module can determine, based on the received detection signal, the status of the second solder ball included in the detection path, in other words, the detection module can monitor the status of the second solder ball.

The designed life of the second solder ball is shorter than the designed life of the first solder ball. Therefore, in a normal case, the second solder ball may crack before the first solder ball. Therefore, when it is detected that the second solder ball cracks, measures may be taken in a timely manner to delay or avoid cracking of the first solder ball, to improve reliability of the chip system.

In a possible implementation, the BGA chip includes a substrate and a die (Die). The substrate has the function pin and the detection pin, the signal source module and the detection module are integrated into the die, and the die includes at least one signal transmitting end and at least one signal receiving end. The detection path includes at least two unit circuits connected in series, both two ends of the detection path are detection pins, and the signal transmitting end and the signal receiving end are electrically connected to the two ends of the detection path respectively.

According to the technical solution provided in this disclosure, both the signal source module and the detection module are integrated into the die, so that the die can send and receive the detection signal, no additional hardware circuit needs to be added to the PCB, and only some detection solder pads on the PCB need to be electrically connected together to implement a serial connection of the unit circuits. This makes the chip system provided in this disclosure easier to implement.

In a possible implementation, the signal source module and the detection module are located on the PCB. The detection path includes at least two unit circuits connected in series, both two ends of the detection path are detection solder pads, and the signal source module and the detection module are electrically connected to the two ends of the detection path respectively.

In a possible implementation, the BGA chip includes a substrate and a die. The substrate has the function pin and the detection pin, the signal source module is integrated into the die, and the detection module is located on the PCB. One end of the detection path is the detection pin, and the other end is the detection solder pad. The die is electrically connected to the detection pin at one end of the detection path, and the detection module is electrically connected to the detection solder pad at the other end of the detection path.

In a possible implementation, the signal source module is located on the PCB, the BGA chip includes a substrate and a die, the substrate has the function pin and the detection pin, and the detection module is integrated into the die. One end of the detection path is the detection solder pad, and the other end is the detection pin. The signal source module is electrically connected to the detection solder pad at one end of the detection path, and the die is electrically connected to the detection pin at the other end of the detection path.

In a possible implementation, the detection pin is closer to an edge of the BGA chip than the function pin.

In a possible implementation, the detection pin is closer to a corner of the BGA chip than the function pin.

In a possible implementation, the second solder ball is closer to the edge of the BGA chip than the first solder ball.

According to the technical solution provided in this disclosure, a stress damage to the BGA chip usually occurs at the edge of the BGA chip. Therefore, the second solder ball is disposed at a position close to the edge and the first solder ball is disposed at a position close to the center, so that the designed life of the second solder ball can be shorter than the designed life of the first solder ball.

In a possible implementation, the second solder ball is closer to the corner of the BGA chip than the first solder ball.

According to the technical solution provided in this disclosure, further, for the edge, the stress damage to the BGA chip is usually more likely to occur at the corner of the BGA chip. Therefore, the second solder ball is disposed at the corner of the BGA chip and the first solder ball is disposed at a position that is not a corner, so that the designed life of the second solder ball can be shorter than the designed life of the first solder ball.

In a possible implementation, an outer diameter of the second solder ball is less than an outer diameter of the first solder ball.

According to the technical solution provided in this disclosure, the first solder ball is less likely to crack than the second solder ball based on the foregoing disposition, so that the designed life of the second solder ball is shorter than the designed life of the first solder ball.

In a possible implementation, strength of a material of the second solder ball is less than strength of a material of the first solder ball.

According to the technical solution provided in this disclosure, the strength of the material of the second solder ball is less than the strength of the material of the first solder ball. Therefore, the second solder ball is more likely to crack than the first solder ball, so that the designed life of the second solder ball is shorter than the designed life of the first solder ball.

In a possible implementation, N levels of detection paths are formed between the BGA chip and the PCB, and a designed life of a second solder ball included in a detection path of an (M-1)^{th} level is shorter than a designed life of a second solder ball included in a detection path of an M^{th} level.

N is an integer greater than 1, and M is any integer greater than 1 and not greater than N.

According to the technical solution provided in this disclosure, the N levels of detection paths are set, and designed lives of second solder balls included in the N levels of detection paths are different, so that a cracking process of the solder ball can be tracked based on statuses of the second solder balls included in the N levels of detection paths, and the status of the first solder ball can be more accurately predicted, so that a corresponding measure can be accurately taken in a more timely manner to delay or even avoid the cracking of the first solder ball, to further improve the reliability of the chip system.

In a possible implementation, a detection path of a first level and a detection path of a second level are formed between the BGA chip and the PCB, there are one or more detection paths of the first level, and there are one or more detection paths of the second level. A designed life of a second solder ball included in the detection path of the first level is shorter than a designed life of a second solder ball included in the detection path of the second level.

In a possible implementation, a detection pin included in the detection path of the (M-1)^{th} level is closer to the edge of the BGA chip than a detection pin included in the detection path of the M^{th} level.

In a possible implementation, a detection pin included in the detection path of the (M-1)^{th} level is closer to the corner of the BGA chip than a detection pin included in the detection path of the M^{th} level.

In a possible implementation, the second solder ball included in the detection path of the (M-1)^{th} level is closer to the edge of the BGA chip than the second solder ball included in the detection path of the M* level.

According to the technical solution provided in this disclosure, the stress damage to the BGA chip is usually more likely to occur at the edge of the BGA chip. Therefore, the designed life of the second solder ball included in the detection path of the (M-1)^{th} level can be shorter than the designed life of the second solder ball included in the detection path of the M* level based on the foregoing disposition.

In a possible implementation, the second solder ball included in the detection path of the (M-1)^{th} level is closer to the corner of the BGA chip than the second solder ball included in the detection path of the M* level.

According to the technical solution provided in this disclosure, further, for the edge, the stress damage to the BGA chip is usually more likely to occur at the corner of the BGA chip. Therefore, the designed life of the second solder ball included in the detection path of the (M-1)^{th} level can be shorter than the designed life of the second solder ball included in the detection path of the M^{th} level based on the foregoing disposition.

In a possible implementation, an outer diameter of the second solder ball included in the detection path of the (M-1)^{th} level is less than an outer diameter of the second solder ball included in the detection path of the M^{th} level.

According to the technical solution provided in this disclosure, the second solder ball included in the detection path of the M* level is less likely to crack than the second solder ball included in the detection path of the (M-1)^{th} level based on the foregoing disposition, so that the designed life of the second solder ball included in the detection path of the (M-1)^{th} level is shorter than the designed life of the second solder ball included in the detection path of the M* level.

In a possible implementation, strength of a material of the second solder ball included in the detection path of the (M-1)^{th} level is less than strength of a material of the second solder ball included in the detection path of the M* level.

According to the technical solution provided in this disclosure, the strength of the material of the second solder ball included in the detection path of the (M-1)^{th} level is less than the strength of the material of the second solder ball included in the detection path of the M* level. Therefore, the second solder ball included in the detection path of the (M-1)^{th} level is more likely to crack than the second solder ball included in the detection path of the M* level, so that the designed life of the second solder ball included in the detection path of the (M-1)^{th} level is shorter than the designed life of the second solder ball included in the detection path of the M* level.

In a possible implementation, both M and N are 2.

In a possible implementation, designed lives of second solder balls belonging to detection paths of a same level are the same.

In a possible implementation, the detection module is configured to: when no detection signal is received through a target detection path, determine that a second solder ball included in the target detection path cracks, where the target detection path is any detection path.

In a possible implementation, the chip system further includes a control module, and the control module is configured to adjust a temperature of the BGA chip based on the status of the detection path determined by the detection module.

In a possible implementation, the control module is configured to: when it is determined that the second solder ball included in the at least one detection path cracks, reduce a temperature fluctuation degree of the BGA chip.

The temperature fluctuation degree of the BGA chip may also be understood as a temperature change range of the BGA chip.

In a possible implementation, the control module is configured to: when it is determined that the second solder ball included in the detection path of the (M-1)^{th} level cracks, reduce the temperature fluctuation degree of the BGA chip through a first operation; and when it is determined that the second solder ball included in the detection path of the M* level cracks, reduce the temperature fluctuation degree of the BGA chip through a second operation.

A temperature fluctuation degree of the BGA chip obtained through the second operation is less than a temperature fluctuation degree of the BGA chip obtained through the first operation.

According to the technical solution provided in this disclosure, a reduced temperature fluctuation degree of the BGA chip adapts to the status of the first solder ball based on the foregoing disposition. This not only prevents rapid deterioration of the status of the first solder ball caused by insufficient reduction of the temperature fluctuation degree, but also prevents an excessive increase in power consumption of the chip system caused by significant reduction of the temperature fluctuation degree.

In a possible implementation, the control module is configured to: when it is determined that a second solder ball included in a detection path of an N^{th} level cracks, report a status message indicating that the BGA chip is abnormal.

In a possible implementation, the control module is configured to: when it is determined that second solder balls included in detection paths of at least two levels crack within target duration, report status information indicating that the BGA chip is abnormal.

In a possible implementation, the control module is configured to: when it is determined that a second solder ball included in a detection path of any level cracks, report status information indicating that the BGA chip is abnormal.

In a possible implementation, the control module is configured to: when it is determined that the second solder ball included in the at least one detection path cracks, control a change range of power consumption of the BGA chip in a working state to be narrowed.

According to the technical solution provided in this disclosure, when the change range of the power consumption of the BGA chip is narrowed, a change range of heat emitted by the BGA chip in the working state is narrowed, to help reduce the temperature fluctuation degree of the BGA chip.

In a possible implementation, the control module is configured to: when it is determined that the second solder ball included in the at least one detection path cracks, reduce a frequency that the BGA chip switches between the working state and a non-working state.

The non-working state may be a sleep state, a power-off state, or the like. Very low or even no power consumption is caused by the BGA chip in the non-working state. Therefore, very little or even no heat is emitted by the BGA chip in the non-working state, and the heat is greatly different from the heat emitted in the working state.

According to the technical solution provided in this disclosure, the frequency that the BGA chip switches between the working state and the non-working state is reduced, so that a quantity of times that the heat emitted by the BGA chip increases greatly and a quantity of times that the heat emitted by the BGA chip decreases greatly are reduced, to help reduce the temperature fluctuation degree of the BGA chip.

In a possible implementation, the control module is configured to: when it is determined that the second solder ball included in the at least one detection path cracks, control a change range of power consumption of a target heat source device in a working state to be narrowed.

The target heat source device is a device whose emitted heat can affect the temperature of the BGA chip.

According to the technical solution provided in this disclosure, when the change range of the power consumption of the target heat source device is narrowed, a change range of heat emitted by the target heat source device in the working state is narrowed, so that the temperature of the BGA chip does not change greatly due to the target heat source device, to help reduce the temperature fluctuation degree of the BGA chip.

In a possible implementation, the control module is configured to: when it is determined that the second solder ball included in the at least one detection path cracks, reduce a frequency that the target heat source device switches between the working state and a non-working state.

According to the technical solution provided in this disclosure, the frequency that the target heat source device switches between the working state and the non-working state is reduced, so that a quantity of times that the heat emitted by the target heat source device increases greatly and a quantity of times that the heat emitted by the target heat source device decreases greatly are reduced, to help reduce the temperature fluctuation degree of the BGA chip.

In a possible implementation, the control module is configured to: when it is determined that the second solder ball included in the at least one detection path cracks, enable a constant-temperature protection circuit.

In a possible implementation, the control module is configured to: when it is determined that the second solder ball included in the at least one detection path cracks, adjust heat dissipation efficiency of a heat dissipation system.

In a possible implementation, the control module and the detection module are integrated into a same component.

According to a second aspect, this disclosure provides a chip system. The chip system includes a BGA chip and a PCB. The BGA chip has a plurality of function pins and at least one detection pin, and the PCB has a plurality of function solder pads and at least one detection solder pad. The function pin is soldered to the function solder pad by using a first solder ball, and the detection pin is soldered to the detection solder pad by using a second solder ball. A designed life of the second solder ball is shorter than a designed life of the first solder ball. At least one detection path is formed between the BGA chip and the PCB. The detection path includes at least two unit circuits connected in series, the unit circuit includes the detection pin, the second solder ball, and the detection solder pad that are connected in sequence, and both two ends of the detection path are detection pins. The BGA chip includes at least one signal transmitting end and at least one signal receiving end, and the signal transmitting end and the signal receiving end are electrically connected to the two ends of the detection path respectively. The BGA chip is configured to send a detection signal via the signal transmitting end, and is configured to determine a status of the at least one detection path based on the detection signal received by the signal receiving end.

According to the technical solution provided in this disclosure, the detection path is formed between the BGA chip and the PCB of the chip system, and the detection path includes the second solder ball. The signal transmitting end of the BGA chip can send the detection signal to the signal receiving end of the BGA chip through the detection path, and the BGA chip can determine, based on the detection signal received by the signal receiving end, a status of the second solder ball included in the detection path, in other words, the BGA chip can monitor the status of the second solder ball. The designed life of the second solder ball is shorter than the designed life of the first solder ball. Therefore, in a normal case, the second solder ball may crack before the first solder ball. Therefore, when it is detected that the second solder ball cracks, measures may be taken in a timely manner to delay or avoid cracking of the first solder ball, to improve reliability of the chip system.

In a possible implementation, the signal transmitting end and the signal receiving end are located on a die of the BGA chip.

According to a third aspect, this disclosure provides a chip system. The chip system includes a BGA chip, a PCB, a signal source module, and a detection module. The BGA chip has a plurality of function pins and at least one detection pin, and the PCB has a plurality of function solder pads and at least one detection solder pad. The function pin is soldered to the function solder pad by using a first solder ball, and the detection pin is soldered to the detection solder pad by using a second solder ball. A designed life of the second solder ball is shorter than a designed life of the first solder ball. At least one detection path is formed between the BGA chip and the PCB, where the detection path includes at least two unit circuits connected in series, the unit circuit includes the detection pin, the second solder ball, and the detection solder pad that are connected in sequence, and both two ends of the detection path are detection solder pads. The signal source module and the detection module are located on the PCB, and the signal source module and the detection module are electrically connected to the two ends of the detection path respectively. The signal source module is configured to send a detection signal to the detection module through the at least one detection path, and the detection module is configured to determine a status of the at least one detection path based on the received detection signal.

According to the technical solution provided in this disclosure, the detection path is formed between the BGA chip and the PCB of the chip system, and the detection path includes the second solder ball. The signal source module can send the detection signal to the detection module through the detection path, and the detection module can determine, based on the received detection signal, the status of the second solder ball included in the detection path, in other words, the detection module can monitor the status of the second solder ball. The designed life of the second solder ball is shorter than the designed life of the first solder ball. Therefore, in a normal case, the second solder ball may crack before the first solder ball. Therefore, when it is detected that the second solder ball cracks, measures may be taken in a timely manner to delay or avoid cracking of the first solder ball, to improve reliability of the chip system.

According to a fourth aspect, this disclosure provides a chip system. The chip system includes a BGA chip, a PCB, and a detection module. The BGA chip has a plurality of function pins and at least one detection pin, and the PCB has a plurality of function solder pads and at least one detection solder pad. The function pin is soldered to the function solder pad by using a first solder ball, and the detection pin is soldered to the detection solder pad by using a second solder ball. A designed life of the second solder ball is shorter than a designed life of the first solder ball. At least one detection path is formed between the BGA chip and the PCB, where the detection path includes one or more unit circuits connected in series, and the unit circuit includes the detection pin, the second solder ball, and the detection solder pad that are connected in sequence. One end of the detection path is the detection pin, and the other end is the detection solder pad. A die of the BGA chip is electrically connected to the detection pin at one end of the detection path, and the detection module is located on the PCB and is electrically connected to the detection solder pad at the other end of the detection path. The die is configured to send a detection signal to the detection module through the at least one detection path, and the detection module is configured to determine a status of the at least one detection path based on the received detection signal.

According to the technical solution provided in this disclosure, the detection path is formed between the BGA chip and the PCB of the chip system, and the detection path includes the second solder ball. The die can send the detection signal to the detection module through the detection path, and the detection module can determine, based on the received detection signal, the status of the second solder ball included in the detection path, in other words, the detection module can monitor the status of the second solder ball. The designed life of the second solder ball is shorter than the designed life of the first solder ball. Therefore, in a normal case, the second solder ball may crack before the first solder ball. Therefore, when it is detected that the second solder ball cracks, measures may be taken in a timely manner to delay or avoid cracking of the first solder ball, to improve reliability of the chip system.

According to a fifth aspect, this disclosure provides a chip system. The chip system includes a BGA chip, a PCB, and a signal source module. The BGA chip has a plurality of function pins and at least one detection pin, and the PCB has a plurality of function solder pads and at least one detection solder pad. The function pin is soldered to the function solder pad by using a first solder ball, and the detection pin is soldered to the detection solder pad by using a second solder ball. A designed life of the second solder ball is shorter than a designed life of the first solder ball. At least one detection path is formed between the BGA chip and the PCB, where the detection path includes one or more unit circuits connected in series, and the unit circuit includes the detection pin, the second solder ball, and the detection solder pad that are connected in sequence. One end of the detection path is the detection solder pad, and the other end is the detection pin. The signal source module is located on the PCB, and is electrically connected to the detection solder pad at one end of the detection path, and a die of the BGA chip is electrically connected to the detection pin at the other end of the detection path. The signal source module is configured to send a detection signal to the die through the at least one detection path, and the die is configured to determine a status of the at least one detection path based on the received detection signal.

According to the technical solution provided in this disclosure, the detection path is formed between the BGA chip and the PCB of the chip system, and the detection path includes the second solder ball. The signal source module can send the detection signal to the die through the detection path, and the die can determine, based on the received detection signal, the status of the second solder ball included in the detection path, in other words, the die can monitor the status of the second solder ball. The designed life of the second solder ball is shorter than the designed life of the first solder ball. Therefore, in a normal case, the second solder ball may crack before the first solder ball. Therefore, when it is detected that the second solder ball cracks, measures may be taken in a timely manner to delay or avoid cracking of the first solder ball, to improve reliability of the chip system.

According to a sixth aspect, this disclosure provides an electronic device. The electronic device has the chip system in any one of the first aspect to the fifth aspect.

In a possible implementation, the electronic device is a communication device, a terminal device, a storage device, or a server.

### BRIEF DESCRIPTION OF DRAWINGS

FIG. 1 is a diagram of a chip system according to an embodiment of this disclosure;
FIG. 2 is a diagram of a chip system according to an embodiment of this disclosure;
FIG. 3 is a diagram of a chip system according to an embodiment of this disclosure;
FIG. 4 is a diagram of a chip system according to an embodiment of this disclosure;
FIG. 5 is a diagram of a chip system according to an embodiment of this disclosure;
FIG. 6 is a diagram of a chip system according to an embodiment of this disclosure;
FIG. 7 is a diagram of a chip system according to an embodiment of this disclosure;
FIG. 8 is a diagram of a chip system according to an embodiment of this disclosure;
FIG. 9 is a diagram of a chip system according to an embodiment of this disclosure;
FIG. 10 is a diagram of a chip system according to an embodiment of this disclosure;
FIG. 11 is a diagram of a chip system according to an embodiment of this disclosure;
FIG. 12 is a diagram of a chip system according to an embodiment of this disclosure;
FIG. 13 is a diagram of a chip system according to an embodiment of this disclosure;
FIG. 14 is a diagram of an arrangement of pins on a BGA chip according to an embodiment of this disclosure;
FIG. 15 is a diagram of an architecture of a chip system according to an embodiment of this disclosure;
FIG. 16 is a diagram of a chip system according to an embodiment of this disclosure;
FIG. 17 is a diagram of a chip system according to an embodiment of this disclosure;
FIG. 18 is a diagram of a chip system according to an embodiment of this disclosure; and
FIG. 19 is a diagram of a chip system according to an embodiment of this disclosure.

### Reference numerals:

1. BGA chip; 10. Detection path; 100. Unit circuit; 11. Substrate; 111. Function pin; 112. Detection pin; 113. Another pin, 12. Die;
2. PCB; 21. Function solder pad; 22. Detection solder pad;
3. Signal source module;
4. Detection module;
5. Control module;
6. First solder ball;
7. Second solder ball;
a. Signal transmitting end; and b. Signal receiving end.

### DESCRIPTION OF EMBODIMENTS

A ball grid array (ball grid array, BGA) chip is soldered to a printed circuit board (printed circuit board, PCB) by using a solder ball, and a signal can be transmitted between the BGA chip and the PCB by using the solder ball.

In a process of using the BGA chip, the solder ball is subject to various types of stress. For example, because a substrate of the BGA chip and the PCB have different coefficients of thermal expansion (coefficients of thermal expansion, CTEs), when temperatures of the BGA chip and the PCB change, expansion degrees of the substrate of the BGA chip and the PCB are different, causing the solder ball to be subject to a shear force. Under action of the various types of stress, the solder ball may be damaged or even crack, affecting a quality of the transmitted signal and even causing a signal disconnection.

To evaluate a condition of the solder ball, a chip system formed by the BGA chip and the PCB is usually modeled and simulated in a related technology, to evaluate stress on the solder ball.

However, modeling parameters and working conditions involved in modeling and simulation are complex, and it is difficult to ensure accuracy of a simulation result. In addition, based on a modeling and simulation method, a cracking process of the solder ball cannot be effectively predicted or tracked, and corresponding protective measures cannot be taken.

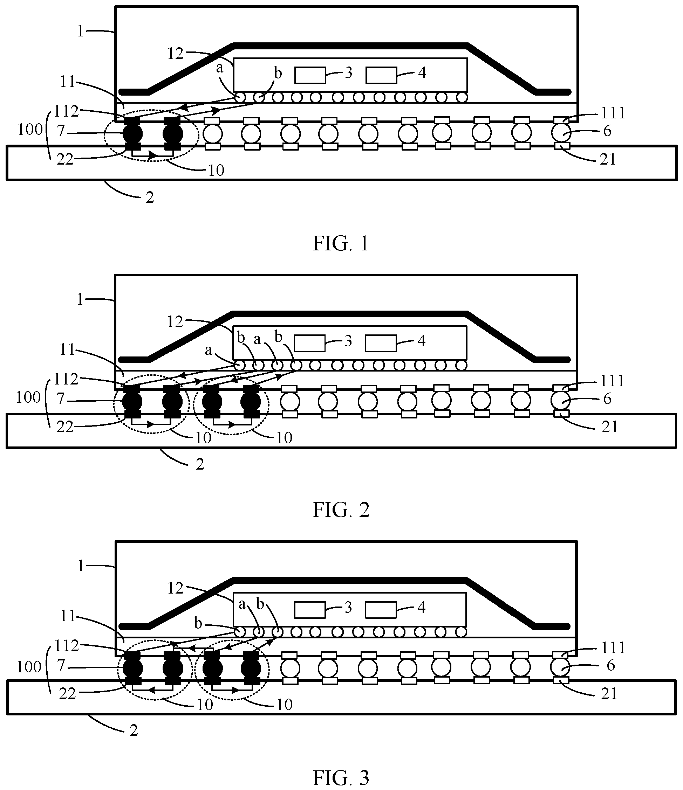

In view of the foregoing technical problem, embodiments of this disclosure provide a chip system. As shown in FIG. 1 to FIG. 13, the chip system includes a BGA chip 1, a PCB 2, a signal source module 3, and a detection module 4. The BGA chip 1 has a plurality of function pins 111 and at least one detection pin 112, and the PCB 2 has a plurality of function solder pads 21 and at least one detection solder pad 22. The function pin 111 is soldered to the function solder pad 21 by using a first solder ball 6, and the detection pin 112 is soldered to the detection solder pad 22 by using a second solder ball 7. A designed life of the second solder ball 7 is shorter than a designed life of the first solder ball 6. At least one detection path 10 is formed between the BGA chip 1 and the PCB 2, each detection path 10 includes one or more unit circuits 100 connected in series, the unit circuit 100 includes the detection pin 112, the second solder ball 7, and the detection solder pad 22 that are connected in sequence. The signal source module 3 is configured to send a detection signal to the detection module 4 through the at least one detection path 10, and the detection module 4 is configured to determine a status of the at least one detection path 10 based on the received detection signal.

The function pin 111 of the BGA chip 1 may be a pin used to implement a basic function of the BGA chip 1, for example, a power pin, a ground pin, and a function pin. The power pin is a pin that provides a connection for a power supply of the BGA chip 1, the ground pin is a pin that provides a connection for grounding the BGA chip 1, and the function pin is a pin that provides a connection for a signal needed by the BGA chip 1. When the first solder ball 6 between the function pin 111 and the function solder pad 21 cracks, a function or performance of the BGA chip 1 may be affected.

The detection pin 112 of the BGA chip 1 may be a pin specially used to monitor a status of the second solder ball 7. The detection pin 112 may not have other functions except status monitoring. When the second solder ball 7 between the detection pin 112, and the detection solder pad 22 cracks, the BGA chip 1 can still work normally. For example, the detection pin 112 may be an original empty pin, also referred to as an NC (Not Connected) pin, on the BGA chip 1.

The function solder pad 21 of the PCB 2 refers to a solder pad soldered to the function pin 111, and the detection solder pad 21 of the PCB 2 refers to a solder pad soldered to the detection pin 112.

The first solder ball 6 is located between the function pin 111 and the function solder pad 21, and the second solder ball 7 is located between the detection pin 112 and the detection solder pad 22. The designed life of the second solder ball 7 is shorter than the designed life of the first solder ball 6. Therefore, in a normal case, the second solder ball 7 may crack before the first solder ball 6. Therefore, a status of the first solder ball 6 may be predicted by monitoring the status of the second solder ball 7.

The signal source module 3 is configured to generate the detection signal, and send the detection signal to the detection module 4 through the detection path 10. The detection module 4 is configured to receive the detection signal through the detection path, and determine the status of the detection path 10 based on the received detection signal, in other words, determine the status of the second solder ball 7 included in the detection path 10. In some examples, the detection module 4 is configured to: when no detection signal is received through a detection path 10, determine that a second solder ball 7 included in the detection path 10 cracks.

According to the technical solution provided in embodiments of this disclosure, the detection path 10 is formed between the BGA chip 1 and the PCB 2 of the chip system, and the detection path 10 includes the second solder ball 7. The signal source module 3 can send the detection signal to the detection module 4 through the detection path 10, and the detection module 4 can determine, based on the received detection signal, the status of the second solder ball 7 included in the detection path 10, in other words, the detection module 4 can monitor the status of the second solder ball 7.

The designed life of the second solder ball 7 is shorter than the designed life of the first solder ball 6. Therefore, the second solder ball 7 may crack before the first solder ball 6. Therefore, when it is detected that the second solder ball 7 cracks, it may be predicted that the first solder ball 6 may crack subsequently. Therefore, measures may be taken in a timely manner to delay or avoid cracking of the first solder ball 6, to improve reliability of the BGA chip 1.

A type of the detection signal is not limited in embodiments of this disclosure. The detection signal may be any signal that meets an interface agreement between the signal source module 3 and the detection module 4. For example, the detection signal is a fixed-level signal, a flipped signal, or the like. The flipped signal is a signal whose level changes with time, and may also be referred to as a time-varying signal.

Positions of the signal source module 3 and the detection module 4 are not limited in embodiments of this disclosure. Both the signal source module 3 and the detection module 4 may be integrated into the BGA chip 1, or may be located on the PCB 2, or one may be integrated into the BGA chip 1, and the other may be located on the PCB 2.

The following describes specific positions of the signal source module 3 and the detection module 4, a corresponding case of the detection path 10, and the like in more detail by using examples.
(1) In some examples, as shown in FIG. 1 to FIG. 4, the BGAchip 1 includes a substrate 11 and a die (Die) 12. The substrate 11 has a function pin 111 and a detection pin 112, the signal source module 3 and the detection module 4 are integrated into the die 12, and the die 12 includes at least one signal transmitting end a and at least one signal receiving end b. The detection path 10 includes at least two unit circuits 100 connected in series, both two ends of the detection path 10 are detection pins 112, and the signal transmitting end a and the signal receiving end b are electrically connected to the two ends of the detection path 10 respectively.

According to the technical solution provided in embodiments of this disclosure, both the signal source module 3 and the detection module 4 are integrated into the die 12, so that the die 12 can send and receive the detection signal, no additional hardware circuit needs to be added to the PCB 2, and only some detection solder pads 21 on the PCB 2 need to be electrically connected together to implement a serial connection of the unit circuits 100. This makes the chip system provided in embodiments of this disclosure easier to implement.

In some examples, as shown in FIG. 1, there is one detection path 10, and the die 12 includes one signal transmitting end a and one signal receiving end b. The signal transmitting end a is electrically connected to a detection pin 112 at one end of the detection path 10, and the signal receiving end b is electrically connected to a detection pin 112 at the other end of the detection path 10.

In some examples, as shown in FIG. 2, there are a plurality of (for example, two) detection paths 10, and the die 12 includes a plurality of (for example, two) signal transmitting ends a and a plurality of (for example, two) signal receiving ends b. The plurality of signal transmitting ends a are electrically connected to detection pins 112 at ends of the plurality of detection paths 10, and the plurality of signal receiving ends b are electrically connected to detection pins 112 at the other ends of the plurality of detection paths 10.

To reduce a quantity of signal transmitting ends a and save resources of the BGA chip 1, in some other examples, as shown in FIG. 3, there are a plurality of (for example, two) detection paths 10, the die 12 includes one signal transmitting end a and a plurality of (for example, two) signal receiving ends b, one signal transmitting end a is electrically connected to all detection pins 112 at ends of the plurality of detection paths 10, and the plurality of signal receiving ends b are electrically connected to detection pins 112 at the other ends of the plurality of detection paths 10 respectively.

It should be noted that, in addition to the foregoing technical solution in which signal transmitting ends whose quantity is the same as that of detection paths 10 are disposed and one signal transmitting end a is disposed, in some other examples, when there are a plurality of detection paths 10, a plurality of signal transmitting ends a may be disposed, but a quantity of the plurality of signal transmitting ends a is less than a quantity of detection paths 10, and at least one signal transmitting end a is electrically connected to detection pins 112 at ends of at least two detection paths 10. Therefore, the quantity of signal transmitting ends a is reduced, and a problem that cabling on the substrate 11 is excessively complex because excessive detection pins 112 are connected to a same signal transmitting end a is avoided.

The following describes possible implementations of the signal transmitting end a and the signal receiving end b by using examples.

In some examples, as shown in FIG. 1 to FIG. 4, the signal transmitting end a is a bump (bump) on the die 12.

In some examples, as shown in FIG. 1 to FIG. 3, the bump may be a bump that is specially reserved on the die 12 and that is used to generate the detection signal.

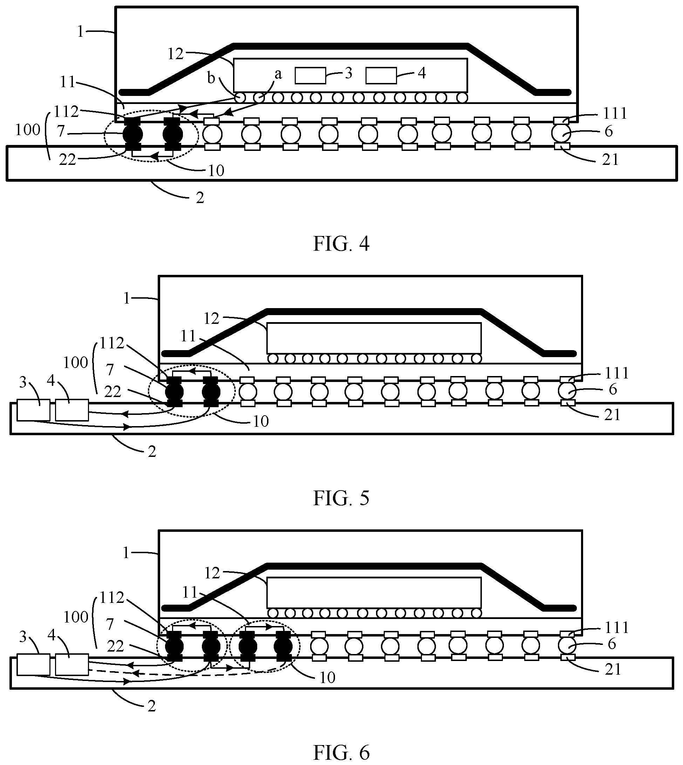

In some examples, as shown in FIG. 4, the bump may alternatively be a bump that is electrically connected to the function pin 111 and that can generate the detection signal. For example, if the bump is a bump used to transmit a clock signal, the detection signal is a time-varying signal. For another example, if the bump is a bump used for power supplying, the detection signal is a fixed-level signal.

In some examples, the signal transmitting end a may not be a bump on the die 12. For example, the signal transmitting end a may be a power module on the die 12, and the power module is electrically connected to the detection pin 112 at one end of the detection path 10. In this case, the detection signal is a fixed-level signal.

In some examples, as shown in FIG. 1 to FIG. 4, the signal receiving end b is a bump on the die 12. In addition, because the die 12 (or the detection module 4) needs to distinguish between detection signals from the plurality of detection paths 10, a quantity of signal receiving ends b is the same as the quantity of detection paths 10, and the signal receiving ends b are in one-to-one correspondence with the detection paths 10.

In addition, it may be understood that, because it needs to be ensured that both the two ends of the detection path 10 are detection pins 112, each detection path 10 needs to include an even number of unit circuits 100.

It should be noted that the chip system shown in FIG. 1 to FIG. 4 may alternatively be described as follows:

Embodiments of this disclosure provide a chip system. As shown in FIG. 1 to FIG. 4, the chip system includes a BGA chip 1 and a PCB 2. The BGA chip 1 has a plurality of function pins 111 and at least one detection pin 112, and the PCB 2 has a plurality of function solder pads 21 and at least one detection solder pad 22. The function pin 111 is soldered to the function solder pad 21 by using a first solder ball 6, and the detection pin 112 is soldered to the detection solder pad 22 by using a second solder ball 7. A designed life of the second solder ball 7 is shorter than a designed life of the first solder ball 6. At least one detection path 10 is formed between the BGA chip 1 and the PCB 2, each detection path 10 includes at least two unit circuits 100 connected in series, the unit circuit 100 includes the detection pin 112, the second solder ball 7, and the detection solder pad 22 that are connected in sequence, and both two ends of the detection path 10 are detection pins 112. The BGA chip 1 includes at least one signal transmitting end a and at least one signal receiving end b, and the signal transmitting end a and the signal receiving end b are electrically connected to the two ends of the detection path 10 respectively. The BGA chip 1 is configured to send a detection signal via the signal transmitting end a, and is configured to determine a status of the detection path 10 based on the detection signal received by the signal receiving end b.

(2) In some examples, as shown in FIG. 5 and FIG. 6, the signal source module 3 and the detection module 4 are located on the PCB 2. The detection path 10 includes at least two unit circuits 100 connected in series, and both two ends of the detection path 10 are detection solder pads 22. The signal source module 3 and the detection module 4 are electrically connected to the two ends of the detection path 10 respectively.

In some examples, as shown in FIG. 5, there is one detection path 10, the signal source module 3 is electrically connected to a detection solder pad 22 at one end of the detection path 10, and the detection module 4 is electrically connected to a detection solder pad 22 at the other end of the detection path 10.

In some other examples, as shown in FIG. 6, there are a plurality of (for example, two) detection paths 10, the signal source module 3 is electrically connected to detection solder pads 22 at ends of the plurality of detection paths 10, and the detection module 4 is electrically connected to detection solder pads 22 at the other ends of the plurality of detection paths 10.

In some examples, the signal source module 3 and the detection module 4 are one or two circuits integrated onto the PCB 2, for example, an integrated circuit (integrated circuit, IC) chip or a discrete device. The signal source module 3 and the detection module 4 may be newly added hardware circuits specially for monitoring a status of the detection path 10, or may be existing hardware circuits on the PCB 2. This is not limited in embodiments of this disclosure.

In addition, it may be understood that, because it needs to be ensured that both the two ends of the detection path 10 are detection solder pads 22, each detection path 10 needs to include an even number of unit circuits 100.

It should be noted that the chip system shown in FIG. 5 and FIG. 6 may alternatively be described as follows:
Embodiments of this disclosure provide a chip system. As shown in FIG. 5 and FIG. 6, the chip system includes a BGA chip 1, a PCB 2, a signal source module 3, and a detection module 4. The BGA chip 1 has a plurality of function pins 111 and at least one detection pin 112, and the PCB 2 has a plurality of function solder pads 21 and at least one detection solder pad 22. The function pin 111 is soldered to the function solder pad 21 by using a first solder ball 6, and the detection pin 112 is soldered to the detection solder pad 22 by using a second solder ball 7. A designed life of the second solder ball 7 is shorter than a designed life of the first solder ball 6. At least one detection path 10 is formed between the BGA chip 1 and the PCB 2, each detection path 10 includes at least two unit circuits 100 connected in series, the unit circuit 100 includes the detection pin 112, the second solder ball 7, and the detection solder pad 22 that are connected in sequence, and both two ends of the detection path 10 are detection solder pads 22. The signal source module 3 and the detection module 4 are located on the PCB 2, and the signal source module 3 and the detection module 4 are electrically connected to the two ends of the detection path 10 respectively. The signal source module 3 is configured to send a detection signal to the detection module 4 through the at least one detection path 10, and the detection module 4 is configured to determine a status of the at least one detection path 10 based on the received detection signal.

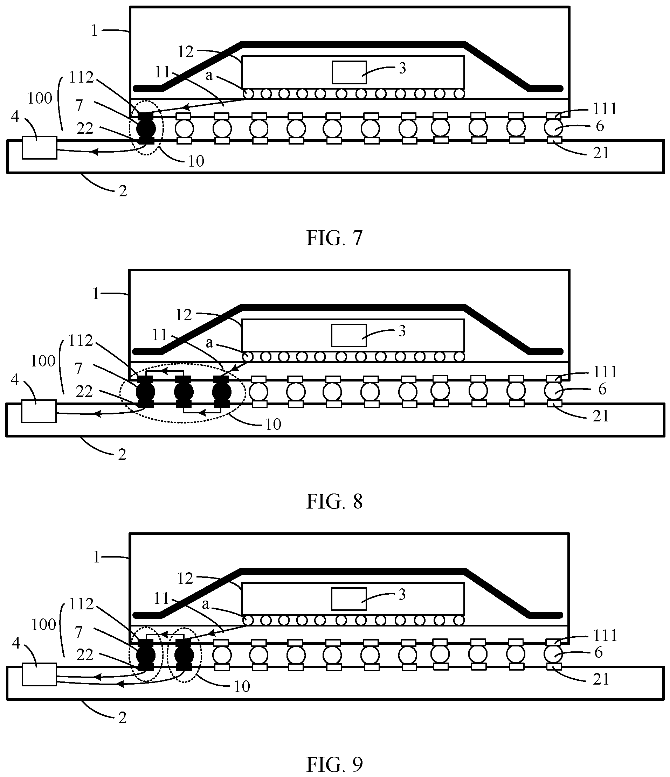

(3) In some examples, as shown in FIG. 7 to FIG. 10, the signal source module 3 is integrated into a die 12, and the detection module 4 is located on the PCB 2. One end of the detection path 10 is the detection pin 112, and the other end is the detection solder pad 22. The die 12 is electrically connected to the detection pin 112 at one end of the detection path 10, and the detection module 4 is electrically connected to the detection solder pad 22 at the other end of the detection path 10.

In some examples, as shown in FIG. 7, there is one detection path 10, the detection path 10 includes one unit circuit 100, and the die 12 includes one signal transmitting end a. The signal transmitting end a is electrically connected to the detection pin 112 at one end of the detection path 10, and the detection module 4 is electrically connected to the detection solder pad 22 at the other end of the detection path 10.

In some examples, as shown in FIG. 8, there is one detection path 10, the detection path 10 includes three unit circuits 100 connected in series, and the die 12 includes one signal transmitting end a. The signal transmitting end a is electrically connected to the detection pin 112 at one end of the detection path 10, and the detection module 4 is electrically connected to the detection solder pad 22 at the other end of the detection path 10.

In some examples, as shown in FIG. 9, there are a plurality of (for example, two) detection paths 10, and the die 12 includes one signal transmitting end a. The signal transmitting end a is electrically connected to detection pins 112 at ends of the plurality of detection paths 10, and the detection module 4 is electrically connected to detection solder pads 22 at the other ends of the plurality of detection paths 10.

A quantity of signal transmitting ends a is reduced based on the disposition, and resources of the BGA chip 1 are saved.

In some other examples, there are a plurality of detection paths 10, and the die 12 includes a plurality of signal transmitting ends a. The plurality of signal transmitting ends a are electrically connected to detection pins 112 at ends of the plurality of detection paths 10, and the detection module 4 is electrically connected to detection solder pads 22 at the other ends of the plurality of detection paths 10.

It should be noted that, in addition to the foregoing technical solution in which signal transmitting ends whose quantity is the same as that of detection paths 10 are disposed and one signal transmitting end a is disposed, in some other examples, when there are a plurality of detection paths 10, a plurality of signal transmitting ends a may be disposed, but a quantity of the plurality of signal transmitting ends a is less than a quantity of detection paths 10, and at least one signal transmitting end a is electrically connected to detection pins 112 at ends of at least two detection paths 10. Therefore, the quantity of signal transmitting ends a is reduced, and a problem that cabling on the substrate 11 is excessively complex because excessive detection pins 112 are connected to a same signal transmitting end a is avoided.

The following describes possible implementations of the signal transmitting end a by using examples.

In some examples, the signal transmitting end a is a bump (bump) on the die 12.

In some examples, as shown in FIG. 7 to FIG. 9, the bump may be a bump that is specially reserved on the die 12 and that is used to generate the detection signal.

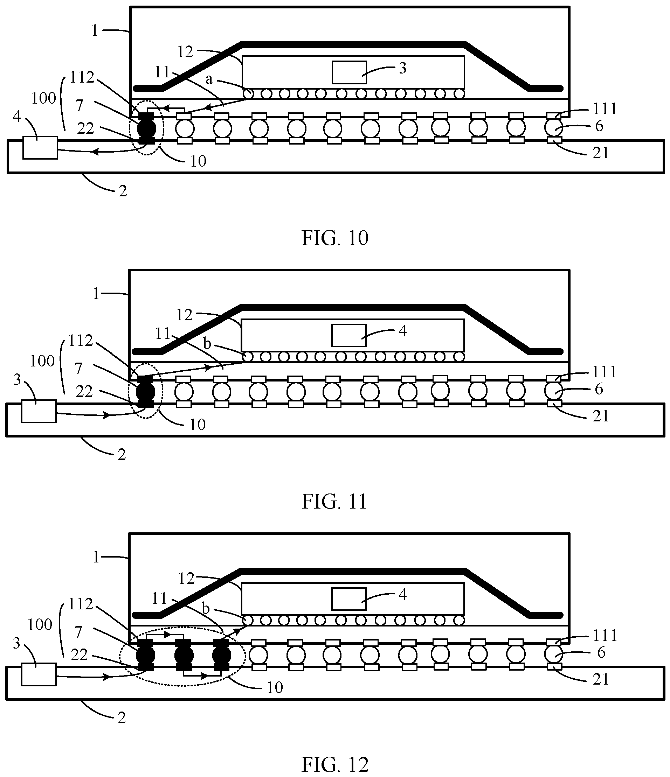

In some other examples, as shown in FIG. 10, the bump may alternatively be a bump that is electrically connected to the function pin 111 and that can generate the detection signal. For example, if the bump is a bump used to transmit a clock signal, the detection signal is a time-varying signal. For another example, if the bump is a bump used for power supplying, the detection signal is a fixed-level signal.

In some examples, the signal transmitting end a may not be a bump on the die 12. For example, the signal transmitting end a may be a power module on the die 12, and the power module is electrically connected to the detection pin 112 at one end of the detection path 10. In this case, the detection signal is a fixed-level signal.

In some examples, the detection module 4 is a circuit integrated onto the PCB 2, for example, an IC chip or a discrete device. The detection module 4 may be a newly added hardware circuit specially for monitoring a status of the detection path 10, or may be an existing hardware circuit on the PCB 2. This is not limited in embodiments of this disclosure.

In addition, it may be understood that, because it needs to be ensured that one end of the detection path 10 is the detection pin 112 and the other end is the detection solder pad 22, each detection path 10 needs to include an odd number of unit circuits 100.

It should be noted that the chip system shown in FIG. 7 to FIG. 10 may alternatively be described as follows:

Embodiments of this disclosure provide a chip system. As shown in FIG. 7 to FIG. 10, the chip system includes a BGA chip 1, a PCB 2, and a detection module 4. The BGA chip 1 has a plurality of function pins 111 and at least one detection pin 112, and the PCB 2 has a plurality of function solder pads 21 and at least one detection solder pad 22. The function pin 111 is soldered to the function solder pad 21 by using a first solder ball 6, and the detection pin 112 is soldered to the detection solder pad 22 by using a second solder ball 7. A designed life of the second solder ball 7 is shorter than a designed life of the first solder ball 6. At least one detection path 10 is formed between the BGA chip 1 and the PCB 2, each detection path 10 includes one or more unit circuits 100 connected in series, the unit circuit 100 includes the detection pin 112, the second solder ball 7, and the detection solder pad 22 that are connected in sequence. One end of the detection path 10 is the detection pin 112, and the other end is the detection solder pad 22. A die 12 of the BGA chip 1 is electrically connected to the detection pin 112 at one end of the detection path 10, and the detection module 4 is located on the PCB 2 and is electrically connected to the detection solder pad 22 at the other end of the detection path 10. The die 12 is configured to send a detection signal to the detection module 4 through the at least one detection path 10, and the detection module 4 is configured to determine a status of the at least one detection path 10 based on the received detection signal.

(4) In some examples, as shown in FIG. 11 to FIG. 13, the signal source module 3 is located on the PCB 2, and the detection module 4 is integrated into the die 12. One end of the detection path 10 is the detection solder pad 22, and the other end is the detection pin 112. The signal source module 3 is electrically connected to the detection solder pad 22 at one end of the detection path 10, and the die 12 is electrically connected to the detection pin 112 at the other end of the detection path 10.

In some examples, as shown in FIG. 11, there is one detection path 10, the detection path 10 includes one unit circuit 100, and the die 12 includes one signal receiving end b. The signal source module 3 is electrically connected to the detection solder pad 22 at one end of the detection path 10, and the signal receiving end b is electrically connected to the detection pin 112 at the other end of the detection path 10.

In some examples, as shown in FIG. 12, there is one detection path 10, the detection path 10 includes three unit circuits 100 connected in series, and the die 12 includes one signal receiving end b. The signal source module 3 is electrically connected to the detection solder pad 22 at one end of the detection path 10, and the signal receiving end b is electrically connected to the detection pin 112 at the other end of the detection path 10.

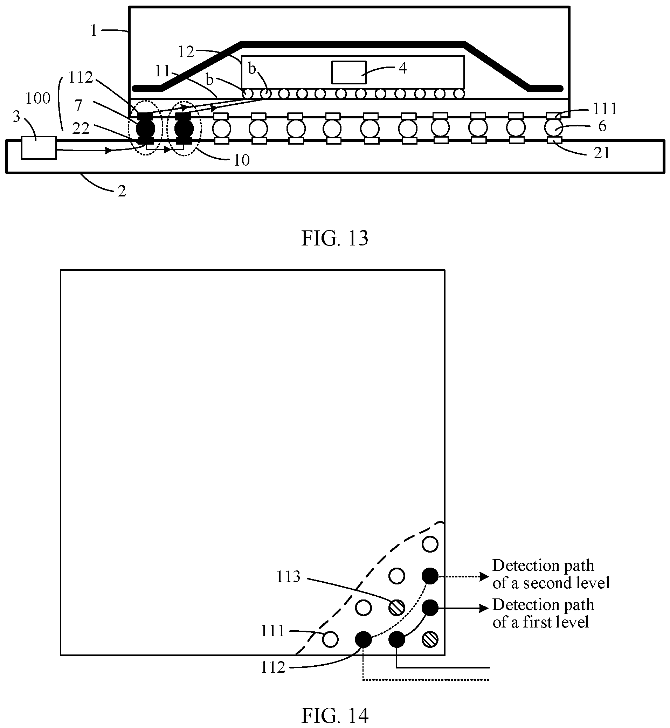

In some examples, as shown in FIG. 13, there are a plurality of (for example, two) detection paths 10, and the die 12 includes a plurality of (for example, two) signal receiving ends b. The signal source module 3 is electrically connected to detection solder pads 22 at ends of the plurality of detection paths 10, and the plurality of signal receiving ends b are electrically connected to detection pins 112 at the other ends of the plurality of detection paths 10 respectively.

In some examples, the signal receiving end b is a bump on the die 12. In addition, because the die 12 (or the detection module 4) needs to distinguish between detection signals from the plurality of detection paths 10, a quantity of signal receiving ends b is the same as a quantity of detection paths 10.

In some examples, the signal source module 3 is a circuit integrated onto the PCB 2, for example, an IC chip or a discrete device. The signal source module 3 may be a newly added hardware circuit specially for monitoring a status of the detection path 10, or may be an existing hardware circuit on the PCB 2. This is not limited in embodiments of this disclosure.

In addition, it may be understood that, because it needs to be ensured that one end of the detection path 10 is the detection solder pad 22 and the other end is the detection pin 112, each detection path 10 needs to include an odd number of unit circuits 100.

It should be noted that the chip system shown in FIG. 11 to FIG. 13 may alternatively be described as follows:
Embodiments of this disclosure provide a chip system. As shown in FIG. 11 to FIG. 13, the chip system includes a BGA chip 1, a PCB 2, and a signal source module 3. The BGA chip 1 has a plurality of function pins 111 and at least one detection pin 112, and the PCB 2 has a plurality of function solder pads 21 and at least one detection solder pad 22. The function pin 111 is soldered to the function solder pad 21 by using a first solder ball 6, and the detection pin 112 is soldered to the detection solder pad 22 by using a second solder ball 7. A designed life of the second solder ball 7 is shorter than a designed life of the first solder ball 6. At least one detection path 10 is formed between the BGA chip 1 and the PCB 2, each detection path 10 includes one or more unit circuits 100 connected in series, and the unit circuit 100 includes the detection pin 112, the second solder ball 7, and the detection solder pad 22 that are connected in sequence. One end of the detection path 10 is the detection solder pad 22, and the other end is the detection pin 112. The signal source module 3 is located on the PCB 2, and is electrically connected to the detection solder pad 22 at one end of the detection path 10, and a die 12 of the BGA chip 1 is electrically connected to the detection pin 112 at the other end of the detection path 10. The signal source module 3 is configured to send a detection signal to the detection module 4 through the at least one detection path 10, and the die 12 is configured to determine a status of the at least one detection path 10 based on the received detection signal.

The designed life of the second solder ball 7 in the chip system provided in embodiments of this disclosure is shorter than the designed life of the first solder ball 6. Therefore, a status of the first solder ball 6 may be predicted by monitoring a status of the second solder ball 7. An implementation in which the designed life of the second solder ball 7 is shorter than the designed life of the first solder ball 6 is not limited in embodiments of this disclosure. The following provides several possible implementations.

In some examples, the second solder ball 7 is closer to an edge of the BGA chip 1 than the first solder ball 6.

A stress damage to the BGA chip 1 is usually likely to occur at the edge of the BGA chip 1. Therefore, the second solder ball 7 is disposed at a position close to the edge and the first solder ball 6 is disposed at a position close to the center, so that the designed life of the second solder ball 7 can be shorter than the designed life of the first solder ball 6.

In some examples, the second solder ball 7 is closer to a corner of the BGA chip 1 than the first solder ball 6.

Further, for the edge, the stress damage to the BGA chip 1 is usually more likely to occur at the corner of the BGA chip 1. Therefore, the second solder ball 7 is disposed at the corner of the BGA chip 1 and the first solder ball 6 is disposed at a position that is not a corner, so that the designed life of the second solder ball 7 can be shorter than the designed life of the first solder ball 6.

FIG. 14 shows an arrangement of pins on the BGA chip 1. It can be learned from the figure that the detection pin 112 is closer to the corner of the BGA chip 1 than the function pin 111, the first solder ball 6 is soldered to the function pin 111, and the second solder ball 7 is soldered to the detection pin 112. Therefore, the second solder ball 7 is closer to the corner of the BGA chip 1 than the first solder ball 6.

In addition, it can be learned from FIG. 14 that, in addition to the function pin 111 and the detection pin 112, the BGA chip 1 further has another pin 113. The another pin 113 may be understood as a pin that is of a same type as the detection pin 112 but is not used to monitor the status of the second solder ball 7. The another pin 113 may be closer to the corner of the BGA chip 1 than the detection pin 112, or may be closer to the center of the BGA chip 1 than the detection pin 112. This is not limited in embodiments of this disclosure.

Certainly, the second solder ball 7 provided in embodiments of this disclosure is not necessarily closer to the edge or the corner of the BGA chip 1 than the first solder ball 6, and the second solder ball 7 may be closer to the center of the BGA chip 1 than the first solder ball 6. For example, when a pin at the edge or the corner of the BGA chip 1 is not suitable for being used as the detection pin 112 due to reasons such as excessive connections, some pins located in the center may be used as the detection pins 112, in other words, the second solder ball 7 may alternatively be close to the center of the BGA chip 1. Certainly, in this case, other methods need to be used to set the designed life of the second solder ball 7 to be shorter than the designed life of the first solder ball 6.

In some examples, an outer diameter of the second solder ball 7 is less than an outer diameter of the first solder ball 6. Therefore, the first solder ball 6 is less likely to crack than the second solder ball 7, so that the designed life of the second solder ball 7 is shorter than the designed life of the first solder ball 6.

In some examples, strength of a material of the second solder ball 7 is less than strength of a material of the first solder ball 6.

The strength of the material of the second solder ball 7 is less than the strength of the material of the first solder ball 6. Therefore, the second solder ball 7 is more likely to crack than the first solder ball 6, so that the designed life of the second solder ball 7 is shorter than the designed life of the first solder ball 6.

For example, the material of the second solder ball 7 is soldering tin, and the material of the first solder ball 6 is soldering tin and an additive (for example, an alloy).

For another example, materials of the second solder ball 7 and the first solder ball 6 are both soldering tin and additives (for example, alloys), but a proportion of an additive included in the second solder ball 7 is different from a proportion of an additive included in the first solder ball 6.

It should be noted that the foregoing several implementations may be used separately, or may be used in any combination. This is not limited in embodiments of this disclosure.

The chip system provided in embodiments of this disclosure may include a plurality of detection paths 10, and a relationship between designed lives of second solder balls 7 included in different detection paths 10 is not limited in embodiments of this disclosure.

In some examples, designed lives of second solder balls 7 included in all the detection paths 10 are the same.

In some other examples, N levels of detection paths 10 are formed between the BGA chip 1 and the PCB 2, and a designed life of a second solder ball 7 included in a detection path 10 of an (M-1)^{th} level is shorter than a designed life of a second solder ball 7 included in a detection path 10 of an M^{th} level.

N is an integer greater than 1, and M is any integer greater than 1 and not greater than N. For example, both N and M are 2. As shown in FIG. 14, two levels of detection paths 10 are formed between the BGA chip 1 and the PCB 2, and a designed life of a second solder ball 7 included in a detection path of a first level is shorter than a designed life of a second solder ball 7 included in a detection path of a second level.

According to the technical solution provided in embodiments of this disclosure, the N levels of detection paths 10 are set, and designed lives of second solder balls 7 included in the N levels of detection paths 10 are different, so that a cracking process of the solder ball can be tracked based on statuses of the second solder balls 7 included in the N levels of detection paths 10, and a status of the first solder ball 6 can be more accurately predicted, so that a corresponding measure can be accurately taken in a more timely manner to delay or even avoid cracking of the first solder ball 6, to further improve reliability of the chip system.

For example, after it is detected that the second solder ball 7 included in the detection path of the first level cracks, a corresponding measure may be taken to delay the cracking of the first solder ball 6. In addition, effects of these measures may be learned of by monitoring a status of a detection path 10 of another level, and the status of the first solder ball 6 may be predicted by continuing to monitor the status of the detection path 10 of the another level. A taken measure may be reducing a temperature fluctuation degree of the BGA chip 1.

When it is detected that a second solder ball 7 included in the detection path 10 of the another level no longer cracks, it indicates that the previously taken measure is effective.

After it is detected that the second solder ball 7 included in the detection path 10 of the another level continues to crack, a more effective measure (for example, continuing to reduce the temperature fluctuation degree of the BGA chip 1) may be taken to delay the cracking of the first solder ball 6, until a second solder ball 7 included in a detection path 10 of a next level no longer cracks, or a second solder ball 7 included in a detection path of a last level also cracks.

When the second solder ball 7 included in the detection path of the last level also cracks, the status of the first solder ball 6 cannot be predicted, and a final measure, that is, a most effective measure, may be taken to delay the cracking of the first solder ball 6. Alternatively, for example, the chip system may be directly repaired or replaced.

In addition, after a corresponding measure is taken, if cracking of a second solder ball 7 included in a detection path 10 of a next level or second solder balls 7 included in detection paths 10 of several next levels within target duration is found, even if the second solder ball 7 included in the detection path of the last level still does not crack, the final measure may also be taken.

The cracking of the second solder ball 7 included in the detection path 10 of the next level or the second solder balls 7 included in the detection paths 10 of the several next levels within the target duration indicates that the status of the first solder ball 6 quickly deteriorates, and the final measure needs to be taken immediately to avoid the cracking of the first solder ball 6. A specific value of the target duration is not limited in embodiments of this disclosure, and the specific value of the target duration may be set by a staff member based on an actual requirement.

It should be additionally noted that, the corresponding measure taken to delay the cracking of the first solder ball 6, for example, reducing the temperature fluctuation degree of the BGA chip 1, causes a specific damage to the chip system or an electronic device including the chip system. For example, to reduce the temperature fluctuation degree of the BGA chip 1, a quantity of times that the BGA chip 1 sleeps may need to be reduced, causing an increase in power consumption of the BGA chip 1.

According to the technical solution provided in embodiments of this disclosure, the N levels of detection paths 10 are set, and after a second solder ball included in a detection path 10 of a higher level cracks, a magnitude of a taken measure is higher (correspondingly, a greater damage is caused to the chip system or the electronic device including the chip system), so that the magnitude of the taken measure adapts to the status of the first solder ball 6, and the magnitude of the taken measure can be correspondingly adjusted based on the status of the first solder ball 6. This avoids a case in which a measure of a higher magnitude is taken when the first solder ball 6 is in a good state, and a case in which a measure of a lower magnitude is still taken when the first solder ball 6 is in a poor state.

When the taken measure is reducing the temperature fluctuation degree of the BGA chip 1, a higher magnitude of the measure indicates a smaller temperature fluctuation degree of the BGA chip 1.

An implementation in which the designed life of the second solder ball 7 included in the detection path 10 of the (M-1)^{th} level is shorter than the designed life of the second solder ball 7 included in the detection path 10 of the M* level is not limited in embodiments of this disclosure. The following provides several possible implementations.

In some examples, the second solder ball 7 included in the detection path 10 of the (M-1)^{th} level is closer to the edge of the BGA chip 1 than the second solder ball 7 included in the detection path 10 of the M* level.

The stress damage to the BGA chip 1 is usually likely to occur at the edge of the BGA chip 1. Therefore, the designed life of the second solder ball 7 included in the detection path 10 of the (M-1)^{th} level can be shorter than the designed life of the second solder ball 7 included in the detection path 10 of the M* level based on the foregoing disposition.

In some examples, the second solder ball 7 included in the detection path 10 of the (M-1)^{th} level is closer to the corner of the BGA chip 1 than the second solder ball 7 included in the detection path 10 of the M* level.

Further, for the edge, the stress damage to the BGA chip 1 is usually more likely to occur at the corner of the BGA chip 1. Therefore, the designed life of the second solder ball 7 included in the detection path 10 of the (M-1)^{th} level can be shorter than the designed life of the second solder ball 7 included in the detection path 10 of the M* level based on the foregoing disposition.

For example, FIG. 14 shows an arrangement of pins on the BGA chip 1. It can be learned from the figure that, the detection pin 112 included in the detection path of the first level is closer to the corner of the BGA chip 1 than the detection pin 112 included in the detection path of the second level. Therefore, the second solder ball 7 included in the detection path of the first level is also closer to the corner of the BGA chip 1 than the second solder ball 7 included in the detection path of the second level.

Certainly, the second solder ball 7 included in the detection path 10 of the (M-1)^{th} level is not necessarily closer to the edge or the corner of the BGA chip 1 than the second solder ball 7 included in the detection path 10 of the M* level. Instead, the designed life of the second solder ball 7 included in the detection path 10 of the (M-1)^{th} level may be set to be shorter than the designed life of the second solder ball 7 included in the detection path 10 of the M* level by using other methods.

In some examples, an outer diameter of the second solder ball 7 included in the detection path 10 of the (M-1)^{th} level is less than an outer diameter of the second solder ball 7 included in the detection path 10 of the M* level. The second solder ball 7 included in the detection path 10 of the M^{th} level is less likely to crack than the second solder ball 7 included in the detection path 10 of the (M-1)^{th} level, so that the designed life of the second solder ball 7 included in the detection path 10 of the (M-1)^{th} level is shorter than the designed life of the second solder ball 7 included in the detection path 10 of the M* level.

In some examples, strength of a material of the second solder ball 7 included in the detection path 10 of the (M-1)^{th} level is less than strength of a material of the second solder ball 7 included in the detection path 10 of the M* level.

The strength of the material of the second solder ball 7 included in the detection path 10 of the (M-1)^{th} level is less than the strength of the material of the second solder ball 7 included in the detection path 10 of the M* level. Therefore, the second solder ball 7 included in the detection path 10 of the (M-1)^{th} level is more likely to crack than the second solder ball 7 included in the detection path 10 of the M^{th} level.

For example, the material of the second solder ball 7 included in the detection path 10 of the (M-1)^{th} level is soldering tin, and the material of the second solder ball 7 included in the detection path 10 of the M^{th} level is soldering tin and an additive (for example, an alloy).

For another example, the materials of the second solder balls 7 are both soldering tin and additives (for example, alloys), but a proportion of an additive included in the second solder ball 7 included in the detection path 10 of the (M-1)^{th} level is different from a proportion of an additive included in the second solder ball 7 included in the detection path 10 of the M* level.

It should be noted that the foregoing several implementations may be used separately, or may be used in any combination. This is not limited in embodiments of this disclosure.

In addition, for detection paths 10 of a same level, designed lives of second solder balls 7 belonging to the detection paths 10 of the same level may be the same.

For example, as shown in FIG. 14, distances from a plurality of detection pins 112 included in the detection path of the first level to an end part of the corner of the BGA chip 1 are basically the same, and distances from a plurality of detection pins 112 included in the detection path of the second level to the end part of the corner of the BGA chip 1 are basically the same.

A measure taken after it is detected that the second solder ball 7 cracks is not limited in embodiments of this disclosure. In some examples, after determining that the second solder ball 7 cracks, the detection module 4 controls sending of an indication message, to indicate a staff member to take a corresponding measure.

In some other examples, the chip system provided in embodiments of this disclosure may further include a control module 5. The control module 5 is configured to perform a corresponding operation based on status information determined by the detection module 4.

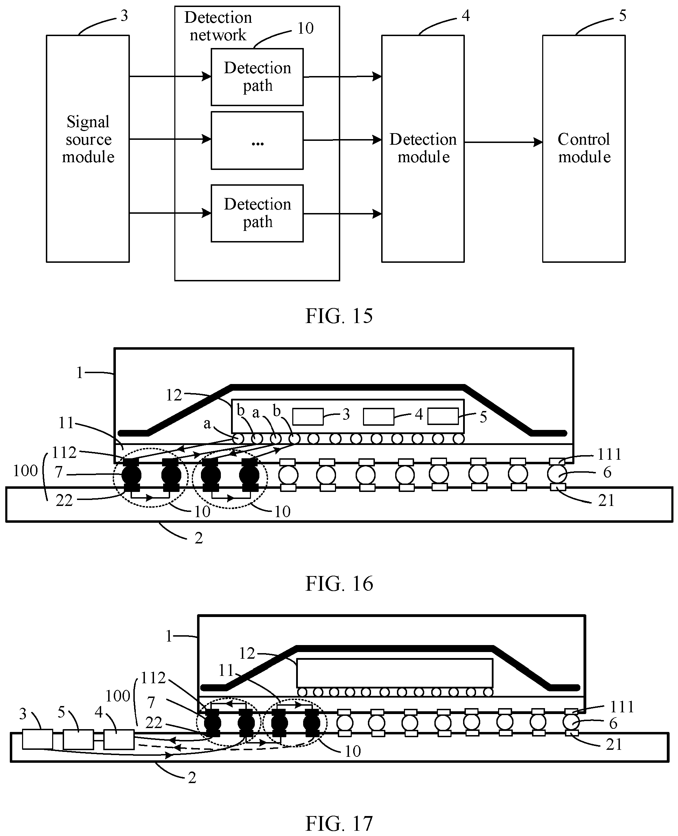

FIG. 15 is a diagram of an architecture of a chip system. The signal source module 3 sends a detection signal to the detection module 4 through each detection path 10 in a detection network. The detection module 4 determines a status of the detection path 10 based on the received detection signal, and sends the determined status of the detection path 10 to the control module 5. The controller 5 performs a corresponding operation based on the status of the detection path 10.

A position of the control module 5 is not limited in embodiments of this disclosure. In some examples, as shown in FIG. 16 to FIG. 19, the control module 5 and the detection module 4 are integrated into a same component. Alternatively, it may be understood that the control module 5 and the detection module 4 are a same module.

For example, as shown in FIG. 16, the signal source module 3, the detection module 4, and the control module 5 are all integrated into the die 12.

For another example, as shown in FIG. 17, the signal source module 3, all the detection module 4, and the control module 5 are located on the PCB board 2.

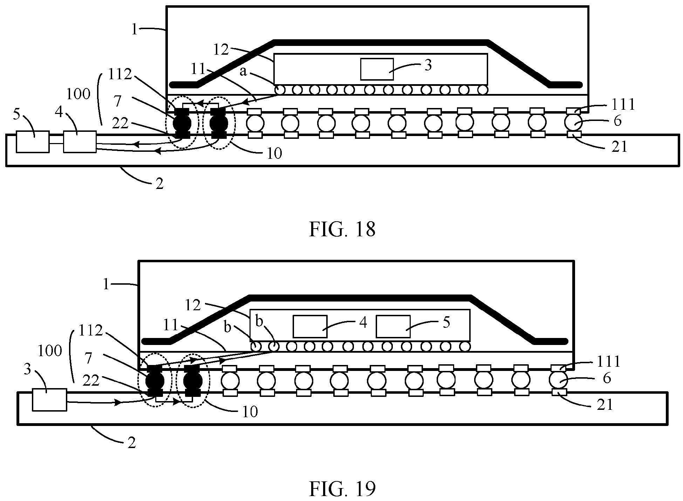

For another example, as shown in FIG. 18, the signal source module 3 is integrated into the die 12, and both the detection module 4 and the control module 5 are located on the PCB board 2.

For another example, as shown in FIG. 19, the signal source module 3 is located on the PCB board 2, and the detection module 4 and the control module 5 are integrated into the die 12.

In some other examples, the control module 5 and the detection module 4 may not be located in a same component. For example, the BGA chip 1 is located in a service board or a switch board in a communication device, and the control module 5 may be located in a main control board. Therefore, the control module 5 can receive status information of the detection path 10 fed back by detection modules 4 in all service boards and switch boards, and perform a corresponding operation.

The following describes, in more detail by using an example, the operation performed by the control module 5 based on the status of the detection path 10.

In some examples, the control module 5 is configured to adjust a temperature of the BGA chip 1 based on the status of the detection path 10 determined by the detection module 4.

During actual application, it is found that when the temperature changes greatly and the temperature changes frequently, stress on the first solder ball 6 and the second solder ball 7 increases and changes frequently, and a possibility of cracking is greatly increased. Therefore, the stress on the first solder ball 6 and the second solder ball 7 can be adjusted by adjusting the temperature of the BGA chip 1.

When the temperature of the BGA chip 1 is adjusted, the power consumption of the BGA chip 1 may be adjusted to adjust heat emitted by the BGA chip 1, or power consumption of a target heat source device may be adjusted. The target heat source device is a device whose emitted heat can affect the temperature of the BGA chip 1.

When it is determined that the second solder ball 7 included in the at least one detection path 10 cracks, to delay the cracking of the first solder ball 6, the control module 5 is configured to reduce the temperature fluctuation degree of the BGA chip 1. In this way, the stress on the first solder ball 6 can be reduced.

The temperature fluctuation degree of the BGA chip 1 may be represented by a variance of the temperature of the BGA chip 1. The temperature fluctuation degree of the BGA chip 1 may also be understood as a temperature difference range, a quantity of temperature change times, and the like of the temperature of the BGA chip 1. The quantity of temperature change times is a quantity of times that a temperature change is greater than a target temperature threshold. Reducing the temperature fluctuation degree of the BGA chip 1 may be understood as one or two of narrowing the temperature difference range of the BGA chip 1 and/or reducing the quantity of temperature change times of the BGA chip 1.

In addition, when there are the N levels of detection paths 10 and when second solder balls 7 included in detection paths 10 of different levels crack, temperature fluctuation degrees of the BGA chip 1 that are reduced by the control module 5 may also be different.

In some examples, the control module 5 is configured to: when it is determined that the second solder ball 7 included in the detection path 10 of the (M-1)^{th} level cracks, reduce the temperature fluctuation degree of the BGA chip 1 through a first operation; and when it is determined that the second solder ball 7 included in the detection path 10 of the M* level cracks, reduce the temperature fluctuation degree of the BGA chip 1 through a second operation.

A temperature fluctuation degree of the BGA chip 1 obtained through the second operation is less than a temperature fluctuation degree of the BGA chip 1 obtained through the first operation. It may be understood that, usually, before the second solder ball 7 included in the detection path 10 of the M* level cracks, the second solder ball 7 included in the detection path 10 of the (M-1)^{th} level has also cracked.

In other words, if a second solder ball 7 in a detection path 10 of a higher level cracks, a temperature fluctuation degree of the BGA chip 1 is smaller after an operation is performed.

In some examples, the control module 5 is configured to: when it is determined that a second solder ball 7 included in a detection path 10 of an N^{th} level cracks, report a status message indicating that the BGA chip 1 is abnormal. In this way, the staff member may be reminded to replace or repair the chip system.

In some examples, when the second solder ball 7 included in the detection path 10 of the N^{th} level cracks, the control module 5 may no longer additionally reduce the temperature fluctuation degree of the BGA chip 1. In some other examples, when reporting status information indicating that the BGA chip 1 is abnormal, the control module 5 may alternatively continue to reduce the temperature fluctuation degree of the BGA chip 1.

In some other examples, the control module 5 is configured to: when it is determined that second solder balls 7 included in detection paths 10 of at least two levels crack within target duration, report status information indicating that the BGA chip 1 is abnormal.

When the second solder balls 7 included in the detection paths 10 of the at least two levels crack within the target duration, it indicates that the status of the first solder ball 6 rapidly deteriorates. In this case, the status information may be reported in a timely manner to remind the staff member to repair or replace the chip system. A specific value of the target duration is not limited in embodiments of this disclosure, and the specific value of the target duration may be set by the staff member based on an actual requirement.

In some other examples, the control module 5 is configured to: when it is determined that a second solder ball 7 included in a detection path 10 of any level cracks, report status information indicating that the BGA chip 1 is abnormal. In addition, the status information may further carry the level of the detection path 10 to which the cracking second solder ball 7 belongs. In this way, the staff member can better understand a status of the BGA chip 1.

An implementation in which the control module 5 reduces the temperature fluctuation degree of the BGA chip 1 is not limited in embodiments of this disclosure. The following provides several possible implementations.

In some examples, the control module 5 is configured to control a change range of power consumption of the BGA chip 1 in a working state to be narrowed.

When the change range of the power consumption of the BGA chip 1 is narrowed, a change range of heat emitted by the BGA chip 1 in the working state is narrowed, to help reduce the temperature fluctuation degree of the BGA chip 1.

In some examples, the control module 5 is configured to reduce a frequency that the BGA chip 1 switches between the working state and a non-working state.

The non-working state may be a sleep state, a power-off state, or the like. Very low or even no power consumption is caused by the BGA chip 1 in the non-working state. Therefore, very little or even no heat is emitted by the BGA chip 1 in the non-working state, and the heat is greatly different from the heat emitted in the working state.

According to the technical solution provided in embodiments of this disclosure, the frequency that the BGA chip 1 switches between the working state and the non-working state is reduced, so that a quantity of times that the heat emitted by the BGA chip 1 increases greatly and a quantity of times that the heat emitted by the BGA chip 1 decreases greatly are reduced, to help reduce the temperature fluctuation degree of the BGA chip 1.

In some examples, the control module 5 is configured to control a change range of power consumption of a target heat source device in a working state to be narrowed.

When the change range of the power consumption of the target heat source device is narrowed, a change range of heat emitted by the target heat source device in the working state is narrowed, so that the temperature of the BGA chip 1 does not change greatly due to the target heat source device, to help reduce the temperature fluctuation degree of the BGA chip 1.

In some examples, the control module 5 is configured to reduce a frequency that the target heat source device switches between the working state and a non-working state.

The frequency that the target heat source device switches between the working state and the non-working state is reduced, so that a quantity of times that heat emitted by the target heat source device increases greatly and a quantity of times that the heat emitted by the target heat source device decreases greatly are reduced, to help reduce the temperature fluctuation degree of the BGA chip 1.

In some examples, the control module 5 is configured to enable a constant-temperature protection circuit. In this way, the temperature of the BGA chip 1 is kept constant as much as possible.

In some examples, the control module 5 is configured to adjust heat dissipation efficiency of a heat dissipation system, for example, adjust a rotation speed of a heat dissipation fan, so that the temperature of the BGA chip 1 is kept as constant as possible.

It should be noted that the foregoing several implementations may be used separately, or may be used in any combination. This is not limited in embodiments of this disclosure. The temperature of the BGA chip 1 may be understood as a temperature of an environment in which the BGA chip 1 is located.

An embodiment of this disclosure further provides an electronic device. The electronic device has the chip system in any one of the foregoing implementations.

A type of the electronic device is not limited in embodiments of this disclosure. The electronic device may be any electronic device having a BGA chip. For example, the electronic device is a communication device, a terminal device, a storage device, or a server.

The foregoing descriptions are merely optional embodiments of this disclosure, but are not intended to limit this disclosure. Any modification, equivalent replacement, or improvement made without departing from the principle of this disclosure should fall within the protection scope of this disclosure.

## Claims

1. A chip system, comprising a ball grid array BGA chip (1), a printed circuit board PCB (2), a signal source module (3), and a detection module (4), wherein
the BGA chip (1) has a plurality of function pins (111) and at least one detection pin (112), the PCB (2) has a plurality of function solder pads (21) and at least one detection solder pad (22), the function pin (111) is soldered to the function solder pad (21) by using a first solder ball (6), the detection pin (112) is soldered to the detection solder pad (22) by using a second solder ball (7), and a designed life of the second solder ball (7) is shorter than a designed life of the first solder ball (6);
at least one detection path (10) is formed between the BGA chip (1) and the PCB (2), the detection path (10) comprises one or more unit circuits (100) connected in series, and the unit circuit (100) comprises the detection pin (112), the second solder ball (7), and the detection solder pad (22) that are connected in sequence;
the signal source module (3) is configured to send a detection signal to the detection module (4) through the at least one detection path (10); and
the detection module (4) is configured to determine a status of the at least one detection path (10) based on the received detection signal.

2. The chip system according to claim 1, wherein the BGA chip (1) comprises a substrate (11) and a die (12), the substrate (11) has the function pin (111) and the detection pin (112), the signal source module (3) and the detection module (4) are integrated into the die (12), and the die (12) comprises at least one signal transmitting end (a) and at least one signal receiving end (b); and
the detection path (10) comprises at least two unit circuits (100) connected in series, both two ends of the detection path (10) are detection pins (112), and the signal transmitting end (a) and the signal receiving end (b) are electrically connected to the two ends of the detection path (10) respectively.

3. The chip system according to claim 1, wherein the signal source module (3) and the detection module (4) are located on the PCB (2); and
the detection path (10) comprises at least two unit circuits (100) connected in series, both two ends of the detection path (10) are detection solder pads (22), and the signal source module (3) and the detection module (4) are electrically connected to the two ends of the detection path (10) respectively.

4. The chip system according to claim 1, wherein the BGA chip (1) comprises a substrate (11) and a die (12), the substrate (11) has the function pin (111) and the detection pin (112), the signal source module (3) is integrated into the die (12), and the detection module (4) is located on the PCB (2); and
one end of the detection path (10) is the detection pin (112), and the other end is the detection solder pad (22); and the die (12) is electrically connected to the detection pin (112) at one end of the detection path (10), and the detection module (4) is electrically connected to the detection solder pad (22) at the other end of the detection path (10).

5. The chip system according to claim 1, wherein the signal source module (3) is located on the PCB (2), the BGA chip (1) comprises a substrate (11) and a die (12), the substrate (11) has the function pin (111) and the detection pin (112), and the detection module (4) is integrated into the die (12); and
one end of the detection path (10) is the detection solder pad (22), and the other end is the detection pin (112); and the signal source module (3) is electrically connected to the detection solder pad (22) at one end of the detection path (10), and the die (12) is electrically connected to the detection pin (112) at the other end of the detection path (10).

6. The chip system according to any one of claims 1 to 5, wherein the second solder ball (7) is closer to an edge of the BGA chip (1) than the first solder ball (6).

7. The chip system according to any one of claims 1 to 6, wherein the second solder ball (7) is closer to a corner of the BGA chip (1) than the first solder ball (6).

8. The chip system according to any one of claims 1 to 7, wherein an outer diameter of the second solder ball (7) is less than an outer diameter of the first solder ball (6).

9. The chip system according to any one of claims 1 to 8, wherein strength of a material of the second solder ball (7) is less than strength of a material of the first solder ball (6).

10. The chip system according to any one of claims 1 to 9, wherein N levels of detection paths (10) are formed between the BGA chip (1) and the PCB (2), and a designed life of a second solder ball (7) comprised in a detection path (10) of an (M-1)^{th} level is shorter than a designed life of a second solder ball (7) comprised in a detection path (10) of an M^{th} level, wherein N is an integer greater than 1, and M is any integer greater than 1 and not greater than N.

11. The chip system according to claim 10, wherein the second solder ball (7) comprised in the detection path (10) of the (M-1)^{th} level is closer to the edge of the BGA chip (1) than the second solder ball (7) comprised in the detection path (10) of the M^{th} level.

12. The chip system according to claim 10 or 11, wherein the second solder ball (7) comprised in the detection path (10) of the (M-1)^{th} level is closer to the corner of the BGA chip (1) than the second solder ball (7) comprised in the detection path (10) of the M^{th} level.

13. The chip system according to any one of claims 10 to 12, wherein an outer diameter of the second solder ball (7) comprised in the detection path (10) of the (M-1)^{th} level is less than an outer diameter of the second solder ball (7) comprised in the detection path (10) of the M* level.

14. The chip system according to any one of claims 10 to 13, wherein strength of a material of the second solder ball (7) comprised in the detection path (10) of the (M-1)^{th} level is less than strength of a material of the second solder ball (7) comprised in the detection path (10) of the M* level.

15. The chip system according to any one of claims 10 to 14, wherein designed lives of second solder balls (7) belonging to detection paths (10) of a same level are the same.

16. The chip system according to any one of claims 1 to 15, wherein the detection module (4) is configured to:
when no detection signal is received through a target detection path, determine that a second solder ball (7) comprised in the target detection path cracks, wherein the target detection path is any detection path (10).

17. The chip system according to any one of claims 1 to 16, wherein the chip system further comprises a control module (5), and the control module (5) is configured to adjust a temperature of the BGA chip (1) based on the status of the detection path (10) determined by the detection module (4).

18. The chip system according to claim 17, wherein the control module (5) is configured to: when it is determined that the second solder ball (7) comprised in the at least one detection path (10) cracks, reduce a temperature fluctuation degree of the BGA chip (1).

19. The chip system according to claim 18, wherein the N levels of detection paths (10) are formed between the BGA chip (1) and the PCB (2), and the designed life of the second solder ball (7) comprised in the detection path (10) of the (M-1)^{th} level is shorter than the designed life of the second solder ball (7) comprised in the detection path (10) of the M* level, wherein N is an integer greater than 1, and M is any integer greater than 1 and not greater than N; and
the control module (5) is configured to:
when it is determined that the second solder ball (7) comprised in the detection path (10) of the (M-1)^{th} level cracks, reduce the temperature fluctuation degree of the BGA chip (1) through a first operation; and
when it is determined that the second solder ball (7) comprised in the detection path (10) of the M* level cracks, reduce the temperature fluctuation degree of the BGA chip (1) through a second operation, wherein a temperature fluctuation degree of the BGA chip (1) obtained through the second operation is less than a temperature fluctuation degree of the BGA chip (1) obtained through the first operation.

20. The chip system according to claim 19, wherein the control module (5) is configured to: when it is determined that a second solder ball (7) comprised in a detection path (10) of an N^{th} level cracks, report a status message indicating that the BGA chip (1) is abnormal.

21. The chip system according to any one of claims 17 to 20, wherein the control module (5) is configured to: when it is determined that the second solder ball (7) comprised in the at least one detection path (10) cracks, perform one or more of the following operations:
controlling a change range of power consumption of the BGA chip (1) in a working state to be narrowed;
reducing a frequency that the BGA chip (1) switches between the working state and a non-working state;
controlling a change range of power consumption of a target heat source device in a working state to be narrowed, wherein the target heat source device is a device whose emitted heat can affect the BGA chip (1);
reducing a frequency that the target heat source device switches between the working state and a non-working state; and
enabling a constant-temperature protection circuit.

22. An electronic device, wherein the electronic device has the chip system according to any one of claims 1 to 21.
